# EUROPEAN PATENT SPECIFICATION

(11) **EP 2 031 039 B1**
(45) Date of publication and mention of the grant of the patent: **11.01.2012**
(21) Application number: 08015119.4
(22) Date of filing: 27.08.2008
(51) Int. Cl.: C09K 11/79

(54) **Light emitting device employing non-stoichiometric tetragonal alkaline earth silicate phosphors**
Leuchtvorrichtung, die nicht-stöchiometrische tetragonale Erdalkalisilikatphosphore einsetzt
Dispositif luminescent utilisant des luminophores de silicates d'alcalino terreux quadratiques non stoïchiométriques

(30) Priority: 28.08.2007 KR 20070086483; 31.07.2008 KR 20080075181
(43) Date of publication of application: 04.03.2009
(73) Proprietor: Seoul Semiconductor Co., Ltd., Seoul 153-801 (KR)
(72) Inventor: Tews, Walter, 17489 Greifswald (DE); Roth, Gundula, 17498 Levenhagen (DE); Tews, Stefan, 17489 Greifswald (DE)
(74) Representative: Scheele, Friedrich

(56) References cited:
- EP-A1- 2 031 038
- WO-A1-2006/043682
- WO-A1-2007/069869
- US-A1- 2005 264 161
- US-A1- 2006 261 309

## Description

### [Field of the invention]

The present invention relates to a light emitting device, more particularly to a light emitting device employing non-stoichiometric tetragonal Alkaline Earth Silicate phosphors, which can be used as temperature stable luminescent material for ultraviolet or visible light excitation.

### [Background of the invention]

A light emitting device (LED) has been widely used for indicators, display boards and display devices since the light emitting device can implement colors. White light can also be implemented, so that the light emitting device has been used for general illumination. Since such a light emitting device has high efficiency and long life span and is ecological, the fields in which the light emitting device is used have been continuously extended.

In the field of LED, various methods for implementing colors, for example white light, have been suggested, and the technique to dispose phosphors around a light emitting diode and combine light emitted from the light emitting diode and light emitted from the phosphors is generally used to implement white light.

In the meantime, stoichiometric silicates such as Orthosilicates, Disilicates and Chlorosilicates are well known as converter materials for short or long wave excitation like ultraviolet as well as daylight radiation. (G. Roth; et al. "Advanced Silicate Phosphors for improved white LED" (Phosphor Global summit Seoul/Korea, March 5-7,2007))

Especially, silicate phosphors excited by blue light from an LED and emitting converted light are used in light emitting devices for implementing white light or color for demand for several applications. In the last years, the use of silicates has been increasing for LED applications.

The LEDs and especially the High Power LEDs produce a lot of heat during operation. Additionally, LEDs have to withstand high ambient temperature above 80°C. Phosphors themselves have a system depending on temperature-behavior. The brightness of most phosphors is decreasing with increasing temperatures.

This so-called temperature quenching depends on the interactions between activator and host lattice and is influenced by the composition of the matrix, structure, lattice effects, concentration as well as the kind of activator. In particular, the strength of the bonding within the crystal matrix is influencing the extension of the lattice parameters and from this the emission properties of the activator ions.

Furthermore, by increasing the temperature the oscillation of the ions within the lattice becomes higher. Because of this, the probability of an interaction with the activator ions becomes higher, resulting in an increasing loss of exciting energy in form of heat. This so-called Photon-Photon Coupling strongly depends on the structure and the surrounding of the activator ions. The more rigid is the crystal lattice, the lower is the interaction between ions and activator.

The brightness of Orthosilicates, Disilicates as well as Chlorosilicates activated by divalent Europium decreases strongly with higher temperatures up to 150°C because the lattice is not so rigid and the strength of the bonding is not so high.

This effect leads e.g. to a changing of the color of the LED during operation. This is a serious disadvantage of the use of common Silicates known until now for LED applications. Furthermore, the sensitivity against water is comparably high caused by the weak lattice and a highly heteropolar bonding between the Silicate ion and the Alkaline Earth ions.

Silicate phosphors have been developed in the recent years as luminescent materials for white LEDs. (WO 02/054503, WO 02/054502, WO 2004/085570)

EP 2 031 038 and US 2006/261309 also discloses LED phosphors comprising tetragonal non-stoichiometric luminescent materials.

Orthosilicates as luminescent material with an excitability from short ultraviolet radiation up to visible light can be used as phosphors for fluorescent lamps. (Barry, T.L., "Fluorescence of Eu2+-activated phases in binary Alkaline Earth Orthosilicate systems," J. Electrochem. Soc., 115, 1181 (1968))

Co-doped Tristrontium-silicates are disclosed as yellow-orange luminescent material (H.G. Kang, J.K. Park, J.M-Kom, S.C. Choi; Solid State Phenomena, Vol 124-126 (2007) 511-514), Divalent europium as activatior for silicates (S.D. Jee, J.K. Park, S.H. Lee; "Photoluminescent properties of Eu2+ activated Sr3SiO5 Phosphors," J. Mater Sci. 41 (2006) 3139-3141 and Barry, T.L.; "Equilibria and Eu2+ luminescence of subsolidus phases bounded by Ba3MgSi2O8, Sr3MgSi2O8 and Ca3MgSi2O8," J. Electrochem. Soc., 115, 733, 1968), and fluorescence for excitation by UV and blue radiation is disclosed in several Silicate systems as Orthosilicates and Disilicates. (G.Blasse, W.L.Wanmaker, J.W. ter Vrugt and a. Bril; "Fluorescence of Europium2+- activated silicates," Philips Res. Repts 23, 189-200, 1968)

All these phosphors have the disadvantage that they have strong temperature quenching and a strong shift of the emission band with the temperature. The emission intensity can be dropped down to 50% at 150°C.

### [Object of the invention]

An object of the present invention is to provide a light emitting device where the decrease of brightness thereof due to the increase of temperature can be prevented or reduced.

Other object of the present invention is to provide a light emitting device with lower sensitivity against water, humidity and polar solvents

Another object of the present invention is to provide a light emitting device, which shows a CRI of 80∼95, especially 90∼95 and has high color temperature range from about 2,000K to 8,000K or 10,000K.

### [Technical Solution]

According to embodiments of the present invention, a light emitting device employing non-stoichiometric tetragonal Alkaline Earth Silicate phosphors is provided. The light emitting device comprises a light emitting diode emitting light of ultraviolet or visible light, and a non-stoichiometric luminescent material disposed around the light emitting diode. The luminescent material adsorbs at least a portion of the light emitted from the light emitting diode and emits light having a different wavelength from the absorbed light. The non-stoichiometric luminescent material has tetragonal crystal structure, and contains more silicon in its crystal lattice than that in the crystal lattice of silicate phosphors having stoichiometric crystal structure.

In addition, the luminescent material contains divalent copper in its matrix and may contain europium as an activator.

The energetic ground level of divalent Europium 4f⁷ can be excited by ultraviolet as well as blue radiation. Divalent Europium emits light in dependence on the crystal field splitting from around 365 nm in the ultraviolet region at small crystal field splitting, e.g. in Tetra borate phosphors, up to 650 nm with red emission at high crystal field splitting, e.g. in Nitrides.

The emission itself depends on both the covalence, the so-called nephelauxetic effect, and the strength of the crystal field. The strength of the crystal field depends on the distance of activator ions and oxygen within the host lattice. Both effects lead to decreasing and splitting of the excited 4f⁶5d level of divalent Europium and result in a shifting of the emission to longer wavelength and smaller energy of the emission.

The difference between exciting radiation and emitting radiation is the Stokes shift. In Orthosilicates, Disilicates as well as Chlorosilicates, the Stode shift is between 160 nm and 360 nm, and depends on the exciting radiation as well as the excitability of divalent Europium within the host lattice.

In Orthosilicates, e.g. the activator ion Europium 2+ is surrounded by oxygen ions in different distance caused by the orthorhombic structure. Best temperature stability has been observed with Barium rich systems, in which the Europium ions have shortened the host lattice and stabilized the crystal structure.

The introduction of more Strontium or Calcium or other cations besides Barium into the Orthosilicate lattice can disturb the symmetry near of the activator ions and leads to energetic traps and stronger interactions between Europium and the lattice traps. These traps play an important role within the temperature quenching process, and the energy transfer process within the crystal is disturbed. Furthermore, the sensitivity against humidity is increasing with increasing number of lattice defects like traps.

An important point is the reduction of interactions between the rare earth metal Europium and the stabilization of its surrounding. That has been realized by developing Tetragonal Copper Alkaline Earth Silicates (CSE) activated by divalent Europium. Divalent Copper ions within tetragonal silicate structure lead to lattice parameters (e.g. (Cu, Sr)₃SiO₅ with a=6.91□; c=9.715□) smaller than for tetragonal lattice without copper (e.g. Sr₃SiO₅ with a=6.93□; c=9.73□).

The lattice parameters are strongly different from lattice parameters of the well-known Orthosilicates with a=5.682□, b=7.09□ and c=9.773□. Here, the surrounding of divalent Europium is influenced by the orthorhombic structure.

Tetragonal Copper Alkaline Earth Silicates show more stable temperature behavior above 100°C. Here, copper is very important for the phosphor preparation. By incorporation of copper into a common Alkaline Earth Silicate, three effects could be obtained.

Firstly, copper is accelerating the solid state reaction during the heating process. Secondly, copper containing phosphors show improved emission intensities compared to luminescent materials having not that component in the host lattice and copper stabilizing the surrounding around the activator. Thirdly, the copper containing phosphors show a shifting of the emission to longer wavelength.

Copper as a basic element doesn't react as activator but the use of this ion leads to an influence on the crystal field splitting as well as the covalence. Surprisingly, the incorporation of copper accelerates the solid state reaction during temperature processing and leads to homogeneous high brightness phosphor which is stable at high temperatures.

Copper(II) has a smaller ionic radius (about 60 pm) and electro-negativity (1.8) is higher than the electro-negativity of Barium, Strontium and Calcium (1). Furthermore, Copper(II) has a positive electrochemical reduction potential of +0.342 in contradiction to the negative potential of Alkaline Earth metals (-2.8 to -2.9). It is shown that copper is stabilizing the emission of Europium within the silicate host lattice.

Furthermore, the water stability can be improved. It is known that Alkaline Earth Silicate phosphors are unstable in water, air humidity, water steam or polar solvents.

Silicates with orthorhombic as well as Akermanite or Merwinite structures show more or less high sensitivity to water, air humidity, water steam or polar solvents caused by high basicity. Due to higher covalence and a lower basicity as well as a positive reduction potential, the incorporation of copper as a basic matrix component in a host lattice improves the behavior of luminescent silicates against water, air humidity, water steam or polar solvents.

The disadvantage of the strong temperature dependence can be overcome by changing the composition of the phosphor and additionally by introducing copper into such a tetragonal silicate matrix and by preparing special non-stoichiometric copper Alkaline Earth Silicates with a high temperature calcinations procedure.

Some embodiments of the present invention employ high temperature stable tetragonal Copper Alkaline Earth Silicate phosphors activated by at least divalent Europium which emits light within the range of 500nm to 630nm. These phosphors show a better stability against water and humidity and can be used with advantage for high brightness LED applications. The phosphors are represented as the following formula 1.

[Formula 1] (BaᵤSrᵥCa_{w}Cuₓ)_{3-y}(Zn,Mg,Mn)_{z}Si_{1+b}O_{5+2b}:Euₐ

Wherein, u+v+w+x=1, y=z+a, z≤2, 0<x≤1, 0<a≤0.5, and 0<b<0.5. And, a tetragonal non-stoichiometric silicate can be provided where Copper is basically an essential part of the matrix.

The phosphors may be made by a multi-step high temperature solid state reaction between the starting materials comprising a surplus of SiO₂ and metal compounds, e. g. metal oxides and metal carbonates, which decompose at high temperatures into oxides. The high temperature solid state reaction may be performed between 800°C and 1550°C.

In the meantime, the light emitting device may implement white light or desired light of color in combination with light emitted from the light emitting diode and light emitted from the luminescent material. For example, white light or desired light of color may be implemented by mixing light emitted from the light emitting diode and light emitted from the luminescent material. Furthermore, other phosphor may be added to implement desired light of color.

For example, the light emitting may implement white light with CRI of Ra=80∼95, especially 90∼95 by the light emitting diode emitting blue light and the luminescent material.

The luminescent material, that is, the phosphor may be disposed on at least one of side, top and bottom faces of the light emitting diode. Further, the phosphor may be mixed into an adhesive or a molding member so that the phosphor can be disposed around the light emitting diode.

In the meantime, the light emitting diode and the luminescent material may be configured within one package. In addition, other light emitting diode may configured within the package. The other light emitting diode may emit light of the same wavelength as or a different wavelength from the above light emitting diode. For example, the other light emitting diode may emit light of longer wavelength than the emission peak wavelength of the luminescent material.

The package may include a substrate comprising a printed circuit board or a lead frame, on which the light emitting diode is mounted. In addition, the package may further comprise a reflector reflecting light emitted from the light emitting diode. In this case, the light emitting diode is mounted in the reflector.

Moreover, the light emitting device may further comprise a molding member encapsulating the light emitting diode on the substrate. The luminescent material may be distributed in the molding member, but not limited thereto.

Further, the package may comprise a heat-sink, and the light emitting diode may be mounted on the heat-sink.

In embodiments of the present invention, the light emitting diode may be formed of (Al, Ga, In)N based composite semiconductor.

The light emitting diode may has, for example, a double heterosutructure, single quantum well structure or multiquantum well structure, which has a single active region between n-type and p-type semiconductor layers.

Otherwise, the light emitting diode may comprise a plurality of light emitting cells spaced apart from one another on a single substrate. Each of the light emitting cells comprises an active region, and these light emitting cells may be connected to one another in series and/or in parallel through wires so that the light emitting cells can be directly driven under AC power supply. Such an AC-light emitting diode can be driven in connection to AC power supply without outer AC-DC converter by forming a bridge rectifier and a series array of light emitting cells connected to the rectifier, or by forming series arrays of light emitting cells on a single substrate, these arrays being electrically connected to each other in anti-parallel.

### [Advantageous effect]

According to the embodiments of the present invention, light emitting devices having improved temperature and humidity stability can be provided by employing the non-stoichiometric tetragonal Alkaline Earth Silicate phosphors. Furthermore, light emitting devices with higher temperature stability and lower sensitivity against water, humidity and polar solvents can be provided as well as with high color temperature range from about 2,000K to 8,000K or 10,000K showing a CRI of 80∼95, especially 90∼95 can be provided by employing tetragonal copper Alkaline Earth Silicate phosphors which are activated by divalent europium (Eu) and emit light having wavelength between about 500nm to 630nm.

### [Embodiments of the invention]

Light emitting devices according to embodiments of the present invention will now be described with reference to the accompanying drawings.

### (Light Emitting Device)

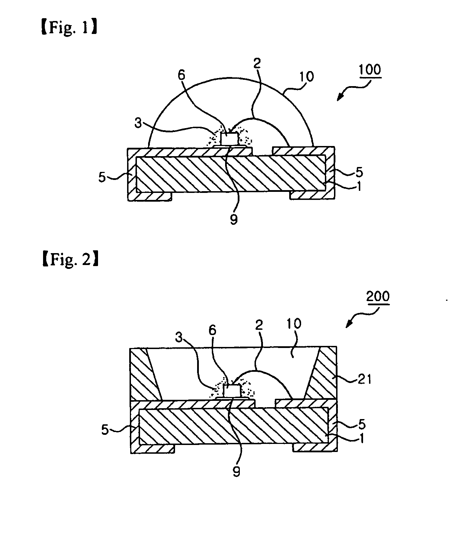

Fig. 1 is a cross-sectional view of a light emitting device 100 according to an embodiment of the present invention. Fig. 1 shows a chip-type package comprising at least one light emitting diode and a luminescent material.

Referring to Fig. 1, electrodes 5 may be formed on both sides of substrate 1. Light emitting diode 6 emitting primary light may be mounted on one of the electrodes 5. The light emitting diode 6 may be mounted on one electrode 5 through electrically conductive paste 9, such as Ag paste, and be connected to other electrode 5 via an electrically conductive wire 2.

The light emitting diode 6 may emit ultraviolet or blue light and can be fabricated of gallium nitride based composite semiconductor. Especially, the light emitting diode 6 emits blue light.

A luminescent material 3 may be placed on the top and side faces of the light emitting diode 6. And, the light emitting diode 6 may be sealed with a molding member 10 formed of thermosetting resin. The luminescent material 3 may be placed near the light emitting diode 3, but it is not limited thereon. The luminescent material 3 can also be uniformly distributed in the molding member 10. Such a method of distributing the luminescent material 3 within the molding member 10 has been disclosed in US Patent NO. 6,482,664.

The luminescent material 3, while being disposed around the light emitting diode 6, adsorbs at least a portion of the light emitted from the light emitting diode and emits light having a different wavelength from the absorbed light. The luminescent material 3 is a non-stoichiometric silicate phosphors having a tetragonal crystal structure and containing mor silicon in its crystal lattice than in the crystal lattice of silicate phosphors having stoichiometric crystal structures. The luminescent material 3 will be described below in detail.

Light emitting diode 6 may be electrically connected to an external power supply through electrodes 5, and thus emits primary light. The luminescent material 3 absorbs at least a portion of the primary light and emits secondary light of a wavelength longer than that of the primary light. As a result, the primary light emitted from the light emitting diode 6 and the secondary light from the luminescent material 3 are mixed together, and the mixed light is emitted from the light emitting device. A desired color of light, for example white light, may be implemented by this mixed light.

The light emitting device 100 can comprise two or more light emitting diodes. These light emitting diodes may have same emission peaks to each other, or may have different emission peaks from each other. For example, the light emitting device 100 may comprise same or different light emitting diodes each emitting ultraviolet or blue light. Furthermore, the light emitting device 100 may comprise a light emitting diode, for example a red light emitting diode, which emits light with a wavelength longer than the emission peak wavelength of the phosphors. Such a longer wavelength light emitting diode may be employed for improving a CRI of the light emitting device 100. Moreover, the light emitting device 100 may further comprise other phosphors in addition to the non-stoichiometric luminescent material 3. The other phosphors may comprise stoichiometric silicate phosphors, YAG based phosphors or thiogallate phosphors, but it is not limited thereto. Accordingly, light of color desired by users can be implemented with proper selection for the light emitting diode 6 and phosphors.

Especially, the light emitting device having high color temperature range from about 2,000K to 8,000K or 10,000K and a CRI of 80∼95, especially 90∼95 can be provided with proper selection for the light emitting diode 6, the luminescent material 3 and other phosphors.

Fig. 2 is a cross-sectional view of a light emitting device 200 according to other embodiment of the present invention. Fig. 2 shows exemplary top-view package having a reflector 21.

Referring to Fig. 2, the light emitting device 200 has a similar structure as that of the above light emitting device 100, and has a reflector 21 on the substrate 1. A light emitting diode 6 is mounted in the reflector 21. The reflector 21 reflects light emitted from the light emitting diode 6 to increase brightness within a certain viewing angle.

In the meantime, as described with reference to Fig. 1, a luminescent material 3, while being disposed around the light emitting diode 6, adsorbs at least a portion of the light emitted from the light emitting diode and emits light having a different wavelength from the absorbed light. The luminescent material 3 are dotted on the light emitting diode 6 in the reflector 21 or uniformly distributed within a thermosetting resin molding member 10. The luminescent material 3 will be described below in detail.

The light emitting device 200 may also comprise two or more light emitting diodes having same emission peaks to each other, or different emission peaks from each other, and may further comprise other phosphors in addition to the non-stoichiometric luminescent material 3, as described with reference to Fig. 1.

In some embodiments of the present invention, the light emitting device 100 or 200 shown in the FIG. 1 or FIG. 2 can include a substrate of a metallic material, for example a metal PCB, which has good heat conductivity. Such a substrate may easily dissipate the heat from the light emitting diode 6. Furthermore, a lead frame including lead terminals may be used as the substrate. Such a leadframe may be surrounded and supported by the molding member 10 encapsulating the light emitting diode.

In Fig. 2, the reflector 21 may be formed of a different material from the substrate 1, but not limited thereto. The reflector 21 may be also formed of the same material as the substrate 1. For example, a lead frame having lead terminals can be insert-molded of a plastic, such as a PPA, which forms the substrate 1 and the reflector 21 together. Then, the lead terminals are bent to form electrodes 5.

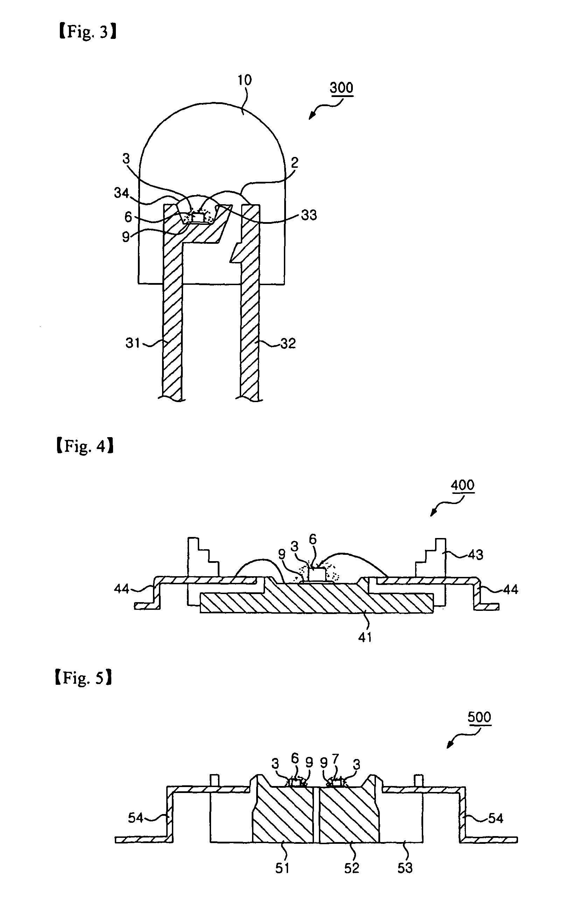

Fig. 3 is a cross-sectional view of a light emitting device 300 according to another embodiment of the present invention. The light emitting device 300 has been known as a light emitting diode ramp.

Referring to Fig. 3, the light emitting device 300 may have a pair of lead electrodes 31, 32, and a cup portion 33 having a shape of cup may be formed at the upper end of one lead electrode 31. At least one light emitting diode 6 may be mounted in the cup portion 33, and electrically connected to the other lead electrode 32 through a conductive wire 2. When a plurality of light emitting diodes is mounted in the cup portion 33, they may emit light of same wavelength or different wavelengths from each other.

Further, a luminescent material 3 is disposed around the light emitting diode 6. As described with reference to Fig. 1, the luminescent material 3, while being disposed around the light emitting diode 6, adsorbs at least a portion of the light emitted from the light emitting diode and emits light having a different wavelength from the absorbed light. The luminescent material 3 are dotted on the light emitting diode 6 in the cup portion 33 or uniformly distributed within a thermosetting resin molding member 34 formed in the cup portion 33. The luminescent material 3 will be described below in detail.

In the meantime, a molding member 10 encapsulates the light emitting diode 6, the luminescent material, and portions of the pair of lead electrodes 31 and 32. The molding member 10 may be formed of epoxy or silicone.

The light emitting device 300 has been described to have a pair of lead electrodes 31 and 32. However, the light emitting device 300 may have more lead electrodes than the pair of lead electrodes 31 and 32.

Fig. 4 is a cross-sectional view of a light emitting device 400 according to yet another embodiment of the present invention. Fig. 4 shows a light emitting diode package for high power.

Referring to Fig. 4, the light emitting device 400 comprises a heat-sink 41 provided in a housing 43. The bottom surface of the heat sink 41 is exposed to outside. Lead electrodes 44 are exposed within the housing 43, and extended through the housing. At least one light emitting diode 6 is mounted on the upper surface of the heat-sink 41 through a electrically conductive adhesive 9, and electrically connected to one of the lead electrodes 44 through a electrically conductive wire. Furthermore, another electrically conductive wire may connect the other lead electrode 44 to the heat-sink 41, such that the light emitting diode 6 can be electrically connected to each of the two lead electrodes 44.

Further, a luminescent material 3 is disposed around the light emitting diode 6 on the heat-sink 41. As described with reference to Fig. 1, the luminescent material 3, while being disposed around the light emitting diode 6, adsorbs at least a portion of the light emitted from the light emitting diode and emits light having a different wavelength from the absorbed light. The luminescent material 3 are dotted on the light emitting diode 6 on the heat-sink 41, or uniformly distributed within a molding member (not shown) covering the light emitting diode. The luminescent material 3 will be described below in detail.

Fig. 5 is a cross-sectional view of a light emitting device 500 according to yet further embodiment of the present invention.

Referring to Fig. 5, the light emitting device 500 comprises a housing 53 and a plurality of heat-sinks 51 and 52 which are joined to the housing and insulated from each other. Light emitting diodes 6 and 7 are mounted on the heat-sinks 51 and 52 through electrically conductive adhesives, and electrically connected to lead electrodes 54 through electrically conductive wires (not shown), respectively. The lead electrodes 54 are extended from inside of the housing 53 to outside. Two lead electrodes 54 are shown in Fig. 5, but more lead electrodes may be provided thereto.

Further, a luminescent material 3 may be disposed around at least one of the light emitting diodes 6 and 7, as described with reference to Fig. 4. The luminescent material 3 will be described below in detail.

In the above embodiments of the present invention, it is described that the light emitting diode 6 is mounted on the substrate 1 or on the heat-sink through the electrically conductive adhesive 9, and electrically connected to the electrode or lead electrode through the electrically conductive wire. These embodiments are limited when the light emitting diode 6 is a "one-bond die," which has its electrodes on the top side and bottom side thereof, respectively. In the case where the light emitting diode 6 is a "two-bond die", which has its two electrodes on the top side thereof, the light emitting diode 6 may be electrically connected to the electrodes or lead electrodes through two electrically conductive wires, respectively. In this case, the adhesive need not to be electrically conductive.

In the embodiments of the present invention, the light emitting diode 6 may be formed of (Al, Ga, In)N based composite semiconductor.

The light emitting diode 6 may has, for example, a double heterosutructure, single quantum well structure or multi-quantum well structure, which has a single active region between n-type and p-type semiconductor layers.

Otherwise, the light emitting diode 6 may comprise a plurality of light emitting cells spaced apart from one another on a single substrate. Each of the light emitting cells comprises an active region, and these light emitting cells may be connected to one another in series and/or in parallel through wires so that the light emitting cells can be directly driven under AC power supply. Such an AC-light emitting diode can be driven in connection to AC power supply without outer AC-DC converter by forming a bridge rectifier and a series array of light emitting cells connected to the rectifier, or by forming series arrays of light emitting cells on a single substrate, these arrays being electrically connected to each other in anti-parallel. The operating voltage of the AC-light emitting diode can be increases up to the voltage for domestic use, for example, 110V or 220V, since the light emitting cells are connected in series. Thus, a light emitting device, which can be driven by domestic power supply, can be provided.

Furthermore, the luminescent material 3 may be disposed between the light emitting diode 6 and the substrate 1 or the heat-sink on which the light emitting diode is mounted, and may be distributed within the adhesive 9. Such a luminescent material 3 adsorbs at least a portion of the light emitted downward from the light emitting diode 6 and emits light having a different wavelength from the absorbed light.

Though several structures for the light emitting device have been described above, the present invention is not limited these structures, and the structure of the light emitting device of the present invention can be modified depending on the kind of the light emitting diode, electrical connection method thereof, a desired viewing angle of light, the purpose to use the light emitting device, etc.

### (Luminescent material)

The luminescent material 3, which is used in embodiments of the present invention, is now described.

The luminescent material is a non-stoichiometric luminescent material, which is a silicate phosphor having tetragonal crystal structure and containing more silicon in the crystal lattice than that in the crystal lattice of silicate phosphors having stoichiometric crystal structure. In addition, the luminescent material contains divalent copper in its matrix and may contain europium as an activator.

Such a luminescent material may be represented as the following formula 1.

[Formula 1] (BaᵤSrᵥCa_{w}Cuₓ)_{3-y}(Zn,Mg,Mn)_{z}Si_{1+b}O_{5+2b}:Euₐ

Wherein, u+v+w+x=1, y=z+a, z≤2, 0<x≤1, 0<a≤0.5, and 0<b<0.5.

The luminescent material is a silicate phosphor having tetragonal crystal structure different from orthosilicate phosphors having orohorhombic crystal structure.

And, a tetragonal non-stoichiometric silicate can be provided where Copper is basically an essential part of the matrix.

The luminescent material may be made by a multi-step high temperature solid state reaction between the starting materials comprising a surplus of SiO₂ and metal compounds, e. g. metal oxides and metal carbonates, which decompose at high temperatures into oxides.

Several examples of the luminescent materials manufactured to use in the light emitting device of the present invention and characteristics thereof are now described.

### (example 1)

Manufacturing method of the luminescent material represented following formula 2 is described.

[Formula 2] Cu_{0.05}Sr_{2.91}Si_{1.05}O_{5.1}:Eu_{0.04}

As starting materials for 1 Mol phosphor, CuO (3.98g), SrCO₃ (429.60g), SiO₂ (63.09g), E_{U2}O₃ (14.08g) and/or any combinations thereof are used. The starting materials in form of very pure oxides as well as carbonates are mixed with the appropriate surplus of Silica together with small amounts of flux (NH₄Cl - 16g). In a first step, the mixture is fired in an alumina crucible at 1,350°C in an inert gas atmosphere (N₂ or noble gas) for 2∼4 hours. After pre-firing, the material is milled. In a second step, the mixture is fired in an alumina crucible at 1,350°C in weakly reducing atmosphere for additional 4 hours. Then, the material is milled, washed, dried and sieved. The luminescent material has an emission maximum at about 580 nm (shown in Fig. 7), and crystallizes in the tetragonal structure (shown in Fig. 8) which is clearly different from the Orthosilicates (shown in Figs. 9 and 10).

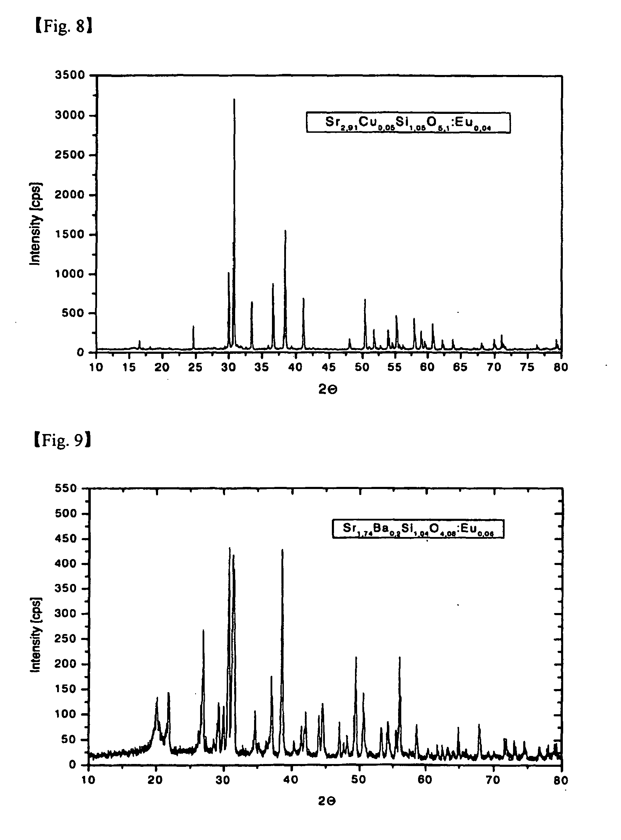

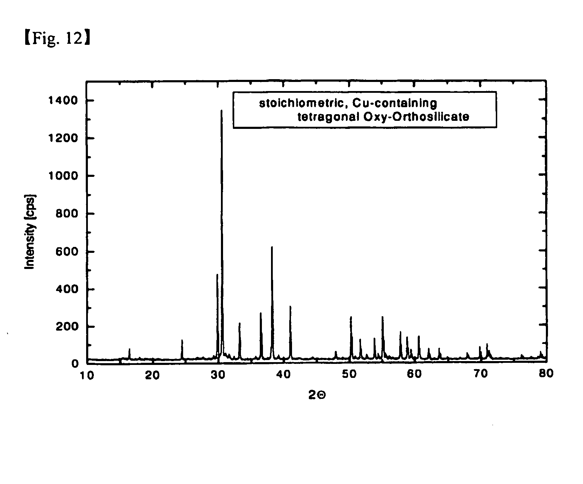

In table 1, results of the X-ray diffraction analysis are written down. There is evidence from Fig. 8-11 and table 1 that the structure has been changed caused by non-stoichiometry and Copper. This difference can also be seen clearly by comparing Fig. 8 for a non-stoichiometric and Fig. 12 for a stoichiometric Oxy-Orthosilicate, especially for the diffraction pattern in the region 2Θ=32-42°.

**[Table 1] Powder X-ray spacing of the 15 strongest reflections (Cu-K_{α1} radiation) of some Silicate phosphors compared with data from Literature.**

| No. | stoichiometric Sr₃SiO 5^{*} | Non-stoichiometric Orthosilicate Sr_{1,78}Ba_{0,16}Eu_{0,06}Si_{1.04}O_{4,08} | Non-stoichiometric Ortho-Disilicate Ba_{2,44}Sr_{0.5}MgEu _{0,06}Si_{2,07}O_{8,14} | Non-stoichiometric Oxy-orthosilicate Sr_{2,94}Cu_{0,02}Eu_{0,04}Si_{1,03}O_{5,06} | Non-stoichiometric Oxy-Orthosilicate Sr_{2,74}Cu_{0,02}Ba_{0,2} Eu_{0,04}Si_{1,03}O_{5,06} | Non-stoichiometric Oxy-Orthosilicate Sr_{2,54}CU₀,₀₂Ba_{0,4} Eu_{0,04}Si_{1,03}O_{5,06} |
|---|---|---|---|---|---|---|
| | [Å] | [nm] | [nm] | [nm] | [nm] | [nm] |
| 1 | 3,595 | 0,4418 | 0,4023 | 0,5388 | 0,3642 | 0,3639 |
| 2 | 3,512 | 0,4063 | 0,2892 | 0,3633 | 0,2992 | 0,2988 |
| 3 | 2,967 | 0,3300 | 0,2793 | 0,2990 | 0,2927 | 0,2925 |
| 4 | 2,903 | 0,3042 | 0,2293 | 0,2923 | 0,2701 | 0,2707 |
| 5 | 2,675 | 0,2904 | 0,2007 | 0,2693 | 0,2461 | 0,2458 |
| 6 | 2,444 | 0,2847 | 0,1821 | 0,2460 | 0,2354 | 0,2356 |
| 7 | 2,337 | 0,2831 | 0,1771 | 0,2352 | 0,2201 | 0,2199 |
| 8 | 2,187 | 0,2416 | 0,1687 | 0,2201 | 0,1899 | 0,1898 |
| 9 | 1,891 | 0,2328 | 0,1630 | 0,1816 | 0,1818 | 0,1820 |
| 10 | 1,808 | 0,2176 | 0,1612 | 0,1771 | 0,1774 | 0,1778 |
| 11 | 1,660 | 0,2055 | 0,1395 | 0,1703 | 0,1705 | 0,1707 |
| 12 | 1,589 | 0,2030 | 0,1338 | 0,1667 | 0,1667 | 0,1666 |
| 13 | 1,522 | 0,1889 | 0,1282 | 0,1595 | 0,1598 | 0,1602 |
| 14 | 1,489 | 0,1842 | 0,1256 | 0,1568 | 0,1569 | 0,1569 |
| 15 | 1,343 | 0,1802 | 0,1206 | 0,1526 | 0,1527 | 0,1528 |

| | | | | | | |
|---|---|---|---|---|---|---|
| * Data from Literature for Sr₃SiO₅ in A (10A = 1nm): R.W. Nurse, *J. Appl. Chem.*, 2, May, 1952, 244-246 | | | | | | |

### (example 2)

Manufacturing method of the luminescent material represented following formula 3 is described.

[Formula 3] Cu_{0.02}Sr_{2.54}Ba_{0.4}Si_{1.03}O_{5.06}:Eu_{0.04}

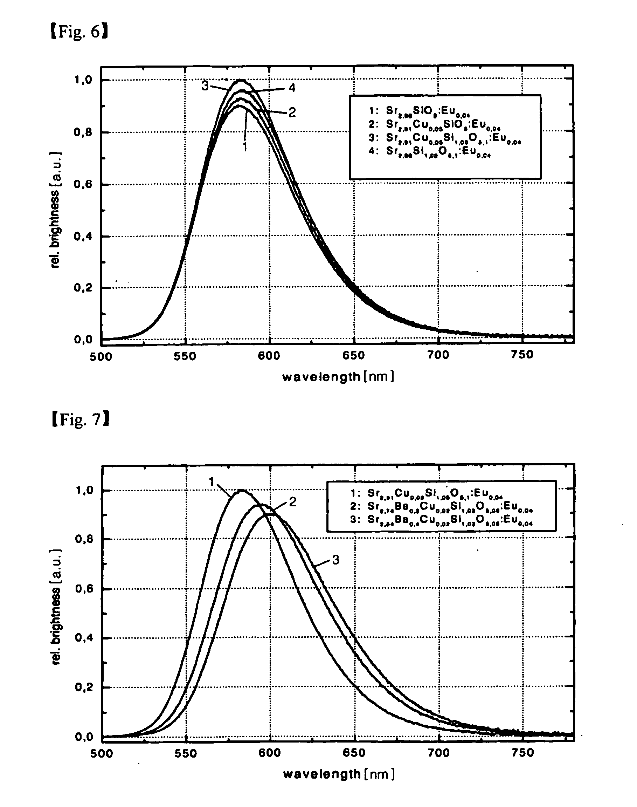

As starting materials for 1 Mol phosphor, CuO (1.59g), SrCO₃ (375g), BaCO₃ (78.94g), SiO₂ (61.89g), Eu₂O₃ (14.08g) and/or any combinations thereof are used. The starting materials in form of very pure oxides as well as carbonates are mixed with a surplus of Silica together with small amounts of flux (NH₄Cl - 26.7g). In a first step, the mixture is fired in an alumina crucible at 1,300°C in an inert gas atmosphere for 2∼6 hours. After pre-firing, the material is milled again. In a second step, the mixture is fired in an alumina crucible at 1,385°C in weakly reducing atmosphere for additional 6 hours. Then, the material is milled, washed, dried and sieved. The luminescent material has an emission maximum at about 600 nm (shown in Fig. 7). The structure is analogously to example 1 as shown in table 1 and Fig. 8.

By substitution of only 0.2 Mol Barium for Strontium results in an emission between 1 and 3 in Fig. 7 and to a change in the structure.

### (example 3)

Manufacturing method of the luminescent material represented following formula 4 is described.

[Formula 4] Cu_{0.03}Sr_{2.92}Ca_{0.01}Si_{1.03}O_{5.06}:Eu_{0.04}

As starting materials, CuO (5.57g), SrCO₃ (431.08g), CaCO₃ (1.0g), SiO₂ (61.89g), Eu₂O₃ (14.08g) and/or any combinations thereof are used. The starting materials in form of very pure oxides as well as carbonates are mixed with a surplus of Silica together with small amounts of flux (NH₄ - 24g). In a first step, the mixture is fired in an alumina crucible at 1,300°C in an inert gas atmosphere for 2∼6 hours. After pre-firing, the material is milled again. In a second step, the mixture is fired in an alumina crucible at 1,370°C in weakly reducing atmosphere for additional 6 hours. Then, the material is milled, washed, dried and sieved. The luminescent material has an emission maximum at 586 nm.

In the following table 2, Relative brightness of various non stoichiometric Copper Alkaline Earth Silicates at 25°C, 100°C, 125°C and 150°C compared with YAG and common Silicate phosphors under 455 nm excitation is summarized.

**[Table 2] Relative brightness of non stoichiometrec Copper Alkaline Earth Silicates at 25°C, 100°C, 125°C and 150°C compared with YAG and common Silicate phosphors under 455 nm excitation**

| Composition | Excitation wavelength | Emission Maximum | 25 °C | 100 °C | 125 °C | 150 °C |
|---|---|---|---|---|---|---|
| | (nm) | (nm) | | | | |
| YAG | 455 | 562 | 100 | 92 | 86 | 79 |
| (Ba,Sr)₂SiO₄:Eu(565nm) | 455 | 565 | 100 | 92 | 78 | 63 |
| (Sr,Ca)₂SiO₄:Eu(612nm) | 455 | 612 | 100 | 87 | 73 | 57 |
| Sr_{2.96}SiO₅:Eu_{0.04} | 455 | 582 | 100 | 96 | 94 | 90 |
| Cu_{0.05}Sr_{2.91}Si_{1.05}O_{5.1}:Eu_{0.04} | 455 | 580 | 100 | 98 | 97 | 94 |
| Cu_{0.05}Sr_{2.51}Ba_{0.4}Si_{1.03}O₅.₀₆:Eu_{0.04} | 455 | 600 | 100 | 96 | 95 | 92 |
| Cu_{0.07}Sr_{2.88}Ca_{0.01}Si_{1.03}O_{5.06}:Eu_{0.04} | 455 | 586 | 100 | 95 | 94 | 91 |
| Cu_{0.1}Ba_{0.1}Sr_{2.56}Mg_{0.1}Mn_{0.1}Si_{1.06}O_{5.12}:Eu_{0.04} | 455 | 575 | 100 | 96 | 94 | 92 |
| Cu_{0.1}Ba_{0.2}Sr₂.₄₆Mg_{0.1}Ca_{0.1}Si_{1.08}O_{5.16}:Eu_{0.04} | 455 | 572 | 100 | 95 | 94 | 91 |
| Cu_{0.2}Ba_{0.1}Sr_{2.56}Zn_{0.1}Si_{1.02}O_{5.04}:Eu_{0.04} | 455 | 574 | 100 | 97 | 95 | 93 |

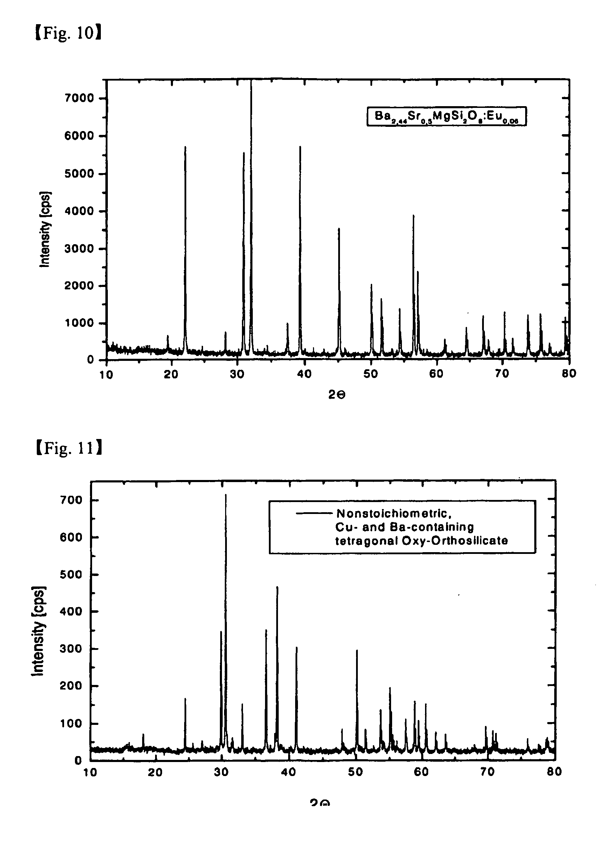

Non-stoichiometric Oxy-Orthosilicates also show higher emission efficiency compared with the stoichiometric ones. In both cases, the incorporation of Cu²⁺ as host component leads to an improvement of brightness and emission efficiency as can be taken from Fig. 10 for typical orange emitting species.

In the following table 3, sensitivity of non-stoichiometric Copper containing new phosphors against humidity and temperature compared to common Silicate phosphors is summarized. Here, the brightness is measured under 450 nm excitation wavelength with time exposed to the condition of 85°C temperature and saturated humidity.

**[Table 3] Sensitivity of non-stoichiometric Copper containing new phosphors against humidity and temperature compared to common Silicate phosphors**

| Sample | Brightness[%] | | | | | |
|---|---|---|---|---|---|---|
| | 0 hrs | 24 hrs | 100 hrs | 200 hrs | 500 hrs | 1000 hrs |
| Commercial yellow | 100 | 98.3 | 98.7 | 93.3 | 84.7 | 79.3 |
| Orthosilicate (565nm) | | | | | | |
| Example 1 | 100 | 99.6 | 99.2 | 97.8 | 94.8 | 91.5 |
| Example 2 | 100 | 98.9 | 99.1 | 96.4 | 93.9 | 90.7 |
| Example 3 | 100 | 99.0 | 98.7 | 98.2 | 95.4 | 93.8 |

All new phosphors show a very good stability against water and humidity as can be taken from table 3.

### [Brief description of drawings]

Fig. 1 is a cross-sectional view of a light emitting device 100 according to an embodiment of the present invention.
Fig. 2 is a cross-sectional view of a light emitting device 200 according to other embodiment of the present invention.
Fig. 3 is a cross-sectional view of a light emitting device 300 according to another embodiment of the present invention.
Fig. 4 is a cross-sectional view of a light emitting device 400 according to yet another embodiment of the present invention.
Fig. 5 is a cross-sectional view of a light emitting device 500 according to yet further embodiment of the present invention.
Fig. 6 shows emission spectra of new non-stoichiometric Oxyorthosilicates compared with stoichiometric phosphors; both with and without Copper at 450 nm excitation wavelength.
Fig. 7 shows the influence of Ba on the emission spectra of new tetragonal Oxyorthosilicates.
Fig. 8 shows X-ray diffraction patterns of a non stoichiometric Copper containing Oxy-Orthosilicate having tetragonal structure.
Fig. 9 shows X-ray diffraction patterns of a non-stoichiometric yellow emitting Orthosilicate having Olivine structure.
Fig. 10 shows X-ray diffraction patterns of a blue emitting Ortho-Disilicate having Merwinite structure.
Fig. 11 shows X-ray diffraction patterns of a non-stoichiometric Oxyorthosilicate with 0.4 Mol Ba.
Fig. 12 shows X-ray diffraction patterns of a stoichiometric Strontium-Oxyorthosilicate.

## Claims

1. Light emitting device comprising;
a light emitting diode; and
a non-stoichiometric luminescent material, while being disposed around the light emitting diode, adsorbing at lease a portion of light emitted from the light emitting diode and emitting light having different wavelength from the absorbed light,
wherein the non-stoichiometric luminescent material being a Silicate phosphor having tetragonal crystal structure and having more silicon in the crystal lattice than that in the crystal lattice of Silicate phosphors having stoichiometric crystal structure, **characterized in that** the luminescent material contains divalent Copper within the matrix and Europium as activator.

2. The light emitting device according to claim 1, wherein the luminescent material comprises a silicate represented as the formula
(BaᵤSrᵥCa_{w}Cuₓ)_{3-y}(Zn,Mg,Mn)_{z}Si_{1+b}O_{5+2b}:Euᵤ,
wherein, u+v+w+x=1, y=z+a, z≤2, 0<x≤1, 0<a_<0.5 and 0<b<0.5.

3. The light emitting device according to any one of claims 1 to 2, wherein the luminescent material is excited by radiation between 250 nm and 500 nm.

4. The light emitting device according to any one of claims 1 to 2, wherein the luminescent material emits light at the long-wave side of the exciting radiation.

5. The light emitting device according to claim 4, wherein the luminescent material emits light having wavelength between 500 nm and 630 nm.

6. The light emitting device according to any one of claims 1 to 2, wherein white light or desired light of color is implemented by mixing light emitted from the light emitting diode and light emitted from the luminescent material.

7. The light emitting device according to any one of claims 1 to 2, implementing white light with CRI of Ra=80∼95 by the light emitting diode emitting blue light and the luminescent material.

8. The light emitting device according to any one of claims 1 to 2, wherein the luminescent material is disposed on at least one of side, top and bottom faces of the light emitting diode.

9. The light emitting device according to claim 8, wherein the luminescent material is mixed into an adhesive or a molding member.

10. The light emitting device according to any one of claims 1 to 2, wherein the light emitting diode and the luminescent material are configure within one package.

11. The light emitting device according to claim 10, further compring; other light emitting diode configured within the package,
wherein the other light emitting diode emits light of longer wavelength than the emission peak wavelength of the luminescent material.

12. The light emitting device according to claim 10, wherein the package comprises a substrate, and
wherein the light emitting diode is mounted on the substrate.

13. The light emitting device according to claim 12, wherein the substrate comprises a printed circuit board or a lead frame,

14. The light emitting device according to claim 13, wherein the package further comprises a reflector, and
Wherein the light emitting diode is mounted in the reflector.

15. The light emitting device according to claim 12, further comprising;
a molding member encapsulating the light emitting diode on the substrate.

16. The light emitting device according to claim 15, wherein the luminescent material is distributed in the molding member.

17. The light emitting device according to claim 10, wherein the package comprises a heat-sink, and
wherein the light emitting diode is mounted on the heat-sink,

18. The light emitting device according to any one of claims 1 to 2, wherein the light emitting diode is an AC-light emitting diode having a plurality of light emitting cells.

## Patentansprüche

1. Lichtemittierende Vorrichtung, mit:
einer lichtemittierenden Diode; und
einem nicht-stöchiometrischen lumineszenzfähigen Material, das, wähnend es um die lichtemittierende Diode herum angeordnet ist, mindestens einen Teil des von der lichtemittierenden Diode emittierten Lichts adsorbiert und Licht emittiert, das eine von dem absorbierten Licht unterschiedliche Wellenlänge aufweist,
wobei das nicht-stöchiometrische lumineszenzfähige Material ein Silikatleuchtstoff ist, der eine tetragonale Kristallstruktur aufweist und mehr Silizium in dem Kristallgitter als das in dem Kristallgitter von Silikatleuchtstoffen mit stoichiometrischer Kristallstruktur aufweist, **dadurch gekennzeichnet, dass** das lumineszenzfähige Material zweiwertiges Kupfer innerhalb der Matrix und Europium als Aktivator enthält.

2. Lichtemittierende Vorrichtung gemäß Anspruch 1, wobei das lumineszenzfähige Material ein Silikat umfasst, das als die Formel
(BaᵤSrᵥCa_{w}Cuₓ)_{3-y}(Zn,Mg,Mn)_{z}Si_{1+b}O_{5+2b}:Euₐ
dargestellt wird, wobei u+v+w+x=1, y=z+a, z≤2, 0<x≤1, 0<a≤0,5 und 0<b<0,5 ist.

3. Lichtemittierende Vorrichtung gemäß einem der Ansprüche 1 bis 2, wobei das lumineszenzfähige Material durch Strahlung zwischen 250 nm und 500 nm angeregt wird.

4. Lichtemittierende Vorrichtung gemäß einem der Ansprüche 1 bis 2, wobei das lumineszenzfähige Material Licht an der der Langwellenseite der anregenden Strahlung emittiert.

5. Lichtemittierende Vorrichtung gemäß Anspruch 4, wobei das lumineszenzfähige Material Licht emittiert, das eine Wellenlänge zwischen 500 nm und 630 nm aufweist.

6. Lichtemittierende Vorrichtung gemäß einem der Ansprüche 1 bis 2, wobei weißes Licht oder gewünschtes Farblich durch Mischen von Licht, das von der lichtemittierende Diode emittiert wird, und Licht, das von dem lumineszenzfähigen Material emittiert wird, implementiert wird.

7. Lichtemittierende Vorrichtung gemäß einem der Ansprüche 1 bis 2, die weißes Licht mit einem CRI von Rₐ=80∼95 durch die blaues Licht emittierende lichtemittierende Diode und das lumineszenzfähige Material implementiert.

8. Lichtemittierende Vorrichtung gemäß einem der Ansprüche 1 bis 2, wobei das lumineszenzfähige Material auf mindestens einer der seitlichen, oberen und unteren Flächen der lichtemittierenden Diode angeordnet ist.

9. Lichtemittierende Vorrichtung gemäß Anspruch 8, wobei das lumineszenzfähige Material in einen Klebstoff oder ein Formteil hinein gemischt wird.

10. Lichtemittierende Vorrichtung gemäß einem der Ansprüche 1 bis 2, wobei die lichtemittierende Diode und das lumineszenzfähige Material innerhalb eines Gehäuses konfiguriert sind.

11. Lichtemittierende Vorrichtung gemäß Anspruch 10, ferner mit einer weiteren lichtemittierende Diode, die innerhalb des Gehäuses konfiguriert ist, wobei die weitere lichtemittierende Diode Licht mit einer längeren Wellenlänge als die Emissions-Spitzenwellenlänge des lumineszenzfähigen Materials emittiert.

12. Lichtemittierende Vorrichtung gemäß Anspruch 10, wobei das Gehäuse ein Substrat umfasst und wobei die lichtemittierende Diode auf dem Substrat angebracht ist.

13. Lichtemittierende Vorrichtung gemäß Anspruch 12, wobei das Substrat eine gedruckte Leiterplatte oder einen Leiterrahmen umfasst.

14. Lichtemittierende Vorrichtung gemäß Anspruch 13, wobei das Gehäuse ferner einen Reflektor umfasst und wobei die lichtemittierende Diole in dem Reflektor angebracht ist.

15. Lichtemittierende Vorrichtung gemäß Anspruch 12, ferner mit einem Formteil, das die lichtemittierende Diode auf dem Substrat verkapselt.

16. Lichtemittierende Vorrichtung gemäß Anspruch 15, wobei das lumineszenzfähige Material in dem Formteil verteilt ist.

17. Lichtemittierende Vorrichtung gemäß Anspruch 10, wobei das Gehäuse eine Wärmesenke umfasst und wobei die lichtemittierende Diode auf der Wärmesenke angebracht ist.

18. Lichtemittierende Vorrichtung gemäß einem der Ansprüche 1 bis 2, wobei die lichtemittierende Diode eine lichtemittierende Diode mit Wechselstrom ist, die eine Mehrzahl von lichtemittierenden Zellen aufweist.

## Revendications

1. Dispositif électroluminescent comprenant:
une diode électroluminescente ; et
un matériau luminescent non stoechiométrique absorbant, tout en étant disposé autour de la diode électroluminescente, au moins une portion de lumière émise depuis la diode électroluminescente et émettant de la lumière ayant une longueur d'onde différente de la lumière absorbée,
dans lequel le matériau luminescent non stoechiométrique est un phosphore de silicate ayant une structure cristalline quadratique et ayant plus de silicium dans le réseau cristallin que celui dans le réseau cristallin de phosphores de silicate ayant une structure cristalline stoechiométrique, **caractérisé en ce que** le matériau luminescent contient du cuivre divalent au sein de la matrice et de l'europium comme activateur.

2. Dispositif électroluminescent selon la revendication 1, dans lequel le matériau luminescent comprend un silicate représenté par la formule
(BaᵤSrᵥCa_{w}Cuₓ)_{3-y}(Zn,Mg,Mn)_{z}Si_{1+b}O_{5+2b}:Euₐ,
dans laquelle u+v+w+x=1, y=z+a, z≤2, 0<x≤1, 0<a≤0,5 et 0<b<0,5.

3. Dispositif électroluminescent selon l'une quelconque des revendications 1 à 2, dans lequel le matériau luminescent est excité par un rayonnement compris entre 250 nm et 500 nm.

4. Dispositif électroluminescent selon l'une quelconque des revendications 1 à 2, dans lequel le matériau luminescent émet de la lumière sur le côté d'ondes longues du rayonnement d'excitation.

5. Dispositif électroluminescent selon la revendication 4, dans lequel le matériau luminescent émet de la lumière ayant une longueur d'onde comprise entre 500 nm et 630 nm.

6. Dispositif électroluminescent selon l'une quelconque des revendications 1 à 2, dans lequel de la lumière blanche ou de la lumière de couleur souhaitée est mise en oeuvre en mélangeant de la lumière émise depuis la diode électroluminescente et de la lumière émise depuis le matériau luminescent.

7. Dispositif électroluminescent selon l'une quelconque des revendications 1 à 2, mettant en oeuvre de la lumière blanche avec un indice de rendu des couleurs de Ra=80~95 par la diode électroluminescente émettant de la lumière bleue et le matériau luminescent.

8. Dispositif électroluminescent selon l'une quelconque des revendications 1 à 2, dans lequel le matériau luminescent est disposé sur au moins une des faces latérales, supérieure et inférieure de la diode électroluminescente.

9. Dispositif électroluminescent selon la revendication 8, dans lequel le matériau luminescent est mélangé dans un élément adhésif ou de moulage.

10. Dispositif électroluminescent selon l'une quelconque des revendications 1 à 2, dans lequel la diode électroluminescente et le matériau luminescent sont configurés au sein d'un emballage.

11. Dispositif électroluminescent selon la revendication 10, comprenant en outre :
une autre diode électroluminescente configurée au sein de l'emballage,
dans lequel l'autre diode électroluminescente émet de la lumière de longueur d'onde plus longue que la longueur d'onde de crête d'émission du matériau luminescent.

12. Dispositif électroluminescent selon la revendication 10, dans lequel l'emballage comprend un substrat, et dans lequel la diode électroluminescente est montée sur le substrat.

13. Dispositif électroluminescent selon la revendication 12, dans lequel le substrat comprend une carte de circuit imprimé ou une grille de connexion.

14. Dispositif électroluminescent selon la revendication 13, dans lequel l'emballage comprend en outre un réflecteur, et
dans lequel la diode électroluminescente est montée dans le réflecteur.

15. Dispositif électroluminescent selon la revendication 12, comprenant en outre :
un élément de moulage encapsulant la diode électroluminescente sur le substrat.

16. Dispositif électroluminescent selon la revendication 15, dans lequel le matériau luminescent est distribué dans l'élément de moulage.

17. Dispositif électroluminescent selon la revendication 10, dans lequel l'emballage comprend un dissipateur thermique, et
dans lequel la diode électroluminescente est montée sur le dissipateur thermique.

18. Dispositif électroluminescent selon l'une quelconque des revendications 1 à 2, dans lequel la diode électroluminescente est une diode électroluminescente à lumière CA ayant une pluralité de cellules électroluminescentes.
